# EUROPEAN PATENT APPLICATION

(11) **EP 1 895 829 A2**
(43) Date of publication of application: **05.03.2008**
(21) Application number: 07102253.7
(22) Date of filing: 13.02.2007
(51) Int. Cl.: H05K 9/00, H01L 23/60

(54) **Shielding device for emi shielding**

(30) Priority: 29.08.2006 CN 200620133054 U
(71) Applicant: Horng, Chin-Fu, Taipei Hsien Lu Chou City (TW)
(72) Inventor: Horng, Chin-Fu, Taipei Hsien Lu Chou City (TW)
(74) Representative: Viering, Jentschura & Partner

(57) **Abstract**

A shielding device for EMI shielding is disposed on a housing (1) or an middle board of an electronic device with an electronic component disposed on a circuit board (5), comprises a shielding cover (2) and an elastic unit (3). The shielding cover (2) is connected on the housing or the middle, the elastic unit (3) is disposed on the shielding cover (2), and the shielding cover (2) is covered on an outside of the electronic component (4), whereby forming a shielding device for EMI shielding that the shielding cover (2) is adapted in various materials to reduce substantially material costs and it is easily to return to shielding status after lifting without installing extra back-shielding upper cover.

## Description

### BACKGROUND OF THE INVENTION

### 1. Field of the invention

The present invention relates to a shielding device, and more particularly to a shielding device is adapted to cover electronic components, such as chips, CPU, and etc. for EMI shielding.

### 2. Description of the Prior Art

A conventional shielding cover is provided to prevent the electromagnetic interference with the operation of the electronic elements as chip, CPU, etc. and the shielding cover is covered on an outer of electronic component installed on a circuit board so as to provide EMI shielding effect.

However, the above-mentioned shielding cover has to be welded on the circuit board by using SMT processing. Hence, adapted materials for the shielding cover are limited and more expensive. Further, if the electronic component needs to be maintained, an upper cover of the shielding cover has to be lifted upwardly and be away from the shielding cover to add extra back-shielding upper cover so as to increase costs.

The inventor of the present invention recognizes the above shortage should be corrected and special effort has been paid to research this field. The present invention is presented with reasonable design and good effect to resolve the above problems.

### SUMMARY OF THE INVENTION

It is an objective of the present invention to provide a shielding device for EMI shielding that the shielding cover is adapted in various materials to reduce substantially material costs and it is easily to return to shielding status after lifting without installing extra back-shielding upper cover.

For achieving the objective stated above, the shielding device for EMI shielding is disposed on a housing of an electronic device with an electronic component disposed on a circuit board, comprises a shielding cover is connected on the housing; an elastic unit is disposed on the shielding cover; and the shielding cover covered on an outside of the electronic component.

Hence, the present invention has the following advantages:
1. The shielding cover doesn't be welded on the circuit board by using SMT processing.
2. The shielding cover is adapted in various materials to reduce substantially material costs.
3. If the electronic component needs to be maintained only if separating the housing and the circuit board so as to apart the electronic component from the shielding cover, and it is easily to cover the shielding cover on the outside of the electronic component as long as to assemble the housing and the circuit board without installing extra back-shielding upper cover.

It is to be understood that both the foregoing general description and the following detailed description are exemplary, and are intended to provide further explanation of the invention as claimed. Other advantages and features of the invention will be apparent from the following description, drawings and claims.

### BRIEF DESCRIPTION OF THE DRAWINGS

The above and further advantages of this invention may be better understood by referring to the following description, taken in conjunction with the accompanying drawings, in which:
Fig. 1 is an exploded perspective view of a first embodiment according to the present invention;
Fig. 2 is a cross-sectional view of the first embodiment according to the present invention;
Fig. 3 is an exploded perspective view of a second embodiment according to the present invention;
Fig. 4 is a cross-sectional view of the second embodiment according to the present invention;
Fig. 5 is an exploded perspective view of a third embodiment according to the present invention;
Fig. 6 is a cross-sectional view of the third embodiment according to the present invention;
Fig. 7 is an exploded perspective view of a fourth embodiment according to the present invention;
Fig. 8 is a cross-sectional view of the fourth embodiment according to the present invention;
Fig. 9 is a plane schematic view of a fifth embodiment according to the present invention;

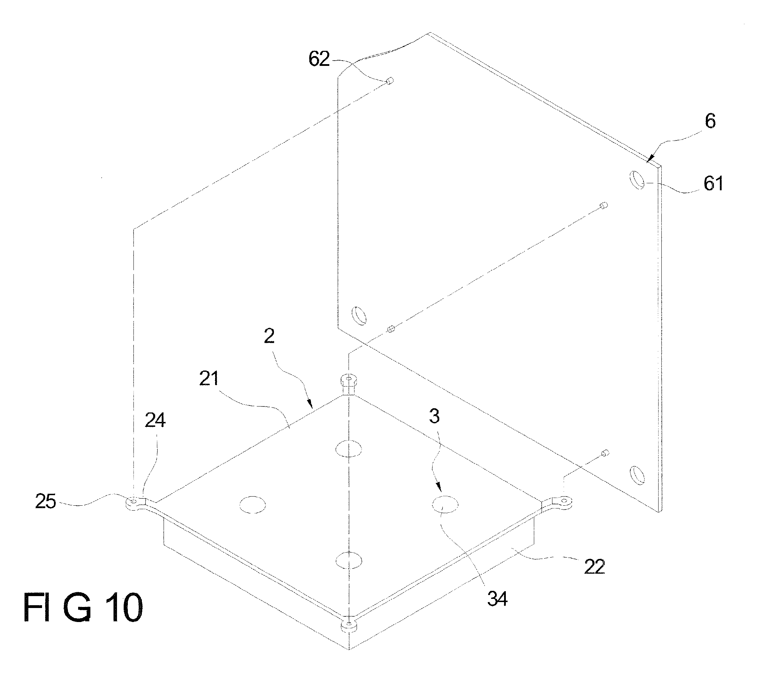

Fig. 10 is an exploded perspective view of the fifth embodiment according to the present invention; and
Fig. 11 is a cross-sectional view of the fifth embodiment according to the present invention.

The drawings will be described further in connection with the following

### Detailed Description of the Invention.

### DETAILED DESCRIPTION OF THE PREFERRED EMBODIMENTS

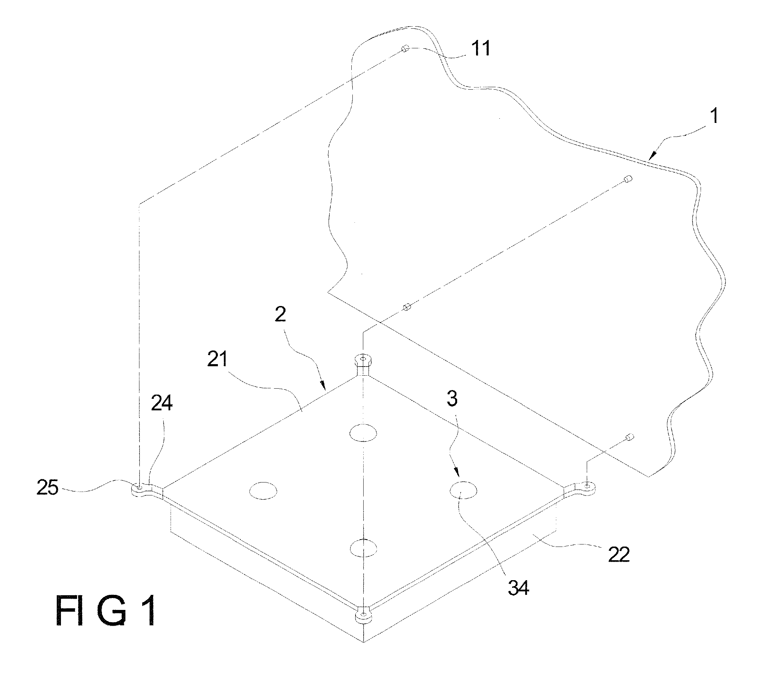

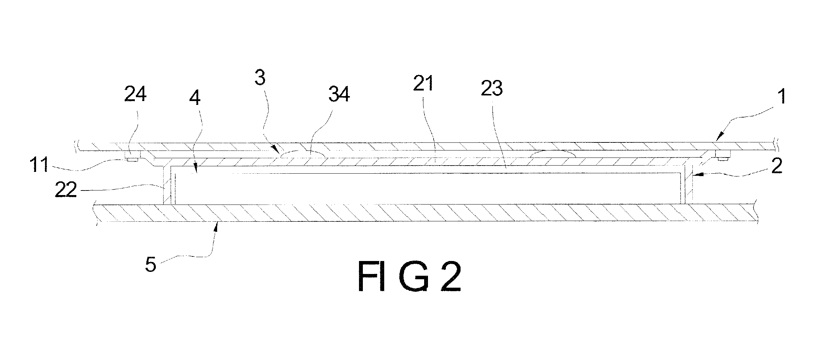

References are shown as in Fig. 1 and Fig. 2. The present invention provides a shielding device for EMI shielding is disposed on a housing **1** of an electronic device and comprises a shielding cover **2** and an elastic unit **3,** wherein the housing **1** is used to fix the shielding cover **2.** The housing **1** has a plurality of connecting elements **11** thereon and the connecting elements **11** can be integrally formed with the housing **1,** or formed on the housing **1** by using a combining method. In this embodiment, the connecting elements **11** are made of fusible material.

The shielding cover **2** is a metal element and is a squared-shaped or other-shaped hollow object and has a top plate **21** and four side plates **22** extended downwardly from edges of the top plate **21,** and a containing space **23** is formed between the top plate **21** and the side plates **22.** The containing space **23** is disposed in the shielding cover **2** to contain an electronic component **4** fixed on a circuit board **5** of the electronic device so that the shielding cover **2** can be covered on an outside of the electronic component **4.**

A lug **24** is formed from each of the four corners of the top plate **21,** each of the lugs **24** has a connecting hole **25** thereon so that the connecting elements **11** can be inserted into the corresponding connecting holes **25** and fixed to the connecting holes **25** by using a heat-melting way so that the shielding cover **2** can be connected to a position corresponded to the electronic component **4** on the housing **1.** The shielding cover **2** can be connected not only by using a heat-melting way on the housing **1** but also by using a rivet-jointing, spot-welding, fastening-jointing, or spiral-jointing way.

A plurality of bumps **34** are formed on the top plate **21** of the shielding cover **2** by using a punching way, and the elastic unit **3** is composed of the bumps **34.** The bumps **34** are protruded on a top surface of the top plate **21** to press a bottom surface of the housing **1** so as to provide a pressed downwardly force to the shielding cover **2** to contact rigidly a bottom edge of the shielding cover **2** and a top surface of the circuit board **5.**

When the housing **1** combines with the circuit board **5,** the shielding cover **2** is covered on an outside of the electronic component **4** to provide an EMI shielding effect so that the electronic component **4** can't be influenced by the EMI.

If the electronic component **4** needs to be maintained only if separating the housing **1** and the circuit board **5** so as to apart the electronic component **4** from the shielding cover **2.** On the other hand, it is easily to cover the shielding cover **2** on the outside of the electronic component **4** as long as to assemble the housing **1** and the circuit board **5.**

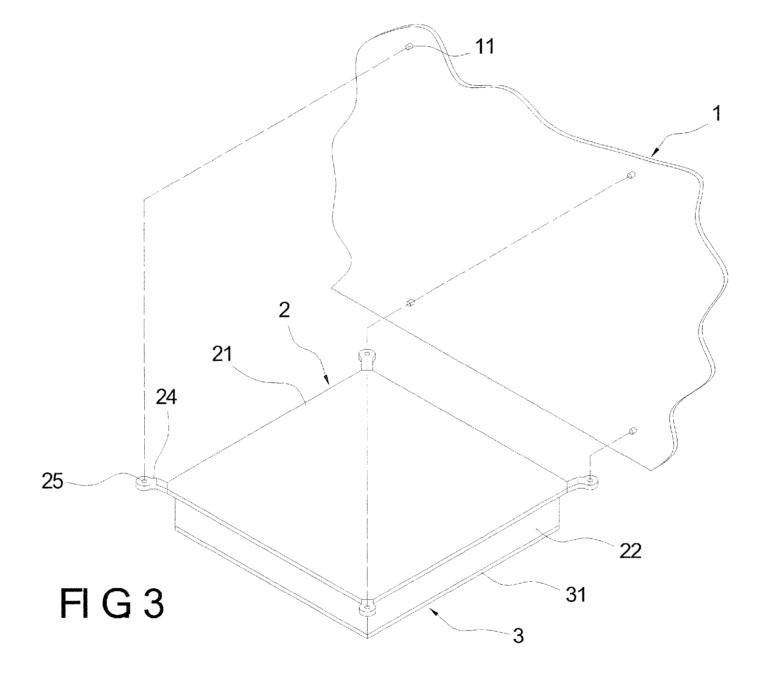

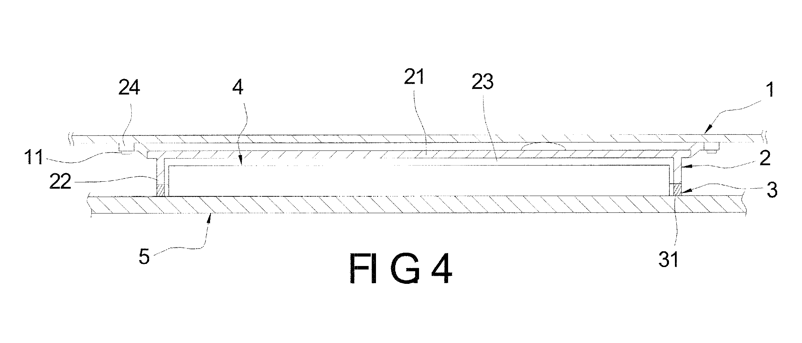

References are shown as in Fig. 3 and Fig. 4. The elastic unit **3** is integrally formed with a bottom edge of the side plate **22** of the shielding cover **2** or disposed on the bottom edge of the side plate **22** by using an assembly way, and in that the elastic unit **3** is a colloid **31.** When the housing **1** combines with the circuit board **5,** the shielding cover **2** is covered on the outside of the electronic component **4** by dispensing to assemble the colloid **31** on the bottom edge of the side plate **22** to contact rigidly the shielding cover **2** and the circuit board **5** so that the electronic component **4** can't be influenced by the EMI.

If the electronic component **4** needs to be maintained only if separating the housing **1,** the circuit board **5,** and the elastic unit **3** so as to apart the electronic component **4** from the shielding cover **2.** On the other hand, it is easily to cover the shielding cover **2** on the outside of the electronic component **4** as long as to assemble the housing **1** and the circuit board **5.**

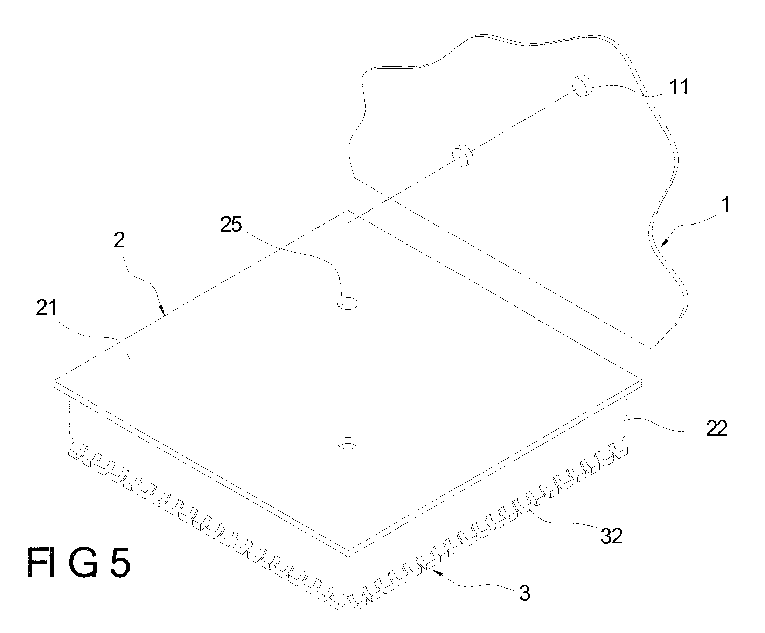

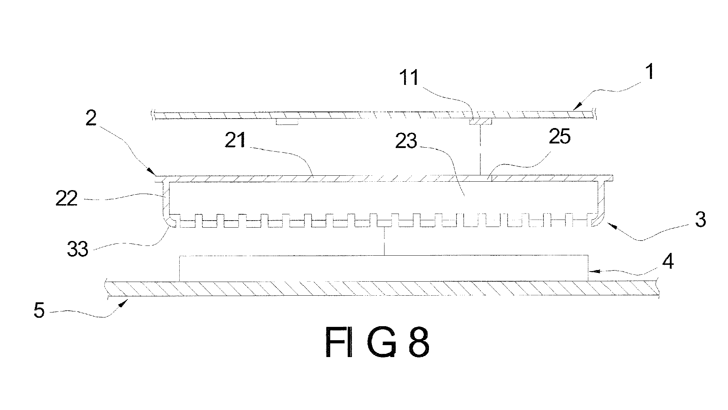

References are shown as in Fig. 5 and Fig. 8. In this embodiment, the connecting holes **25** are disposed directly on the top plate **21** of the shielding cover **2.** The connecting element **11** is connected with the connecting holes **25** by using a heat-melting way so that the shielding cover **2** can be connected to a position corresponded to the electronic component **4** on the housing **1.**

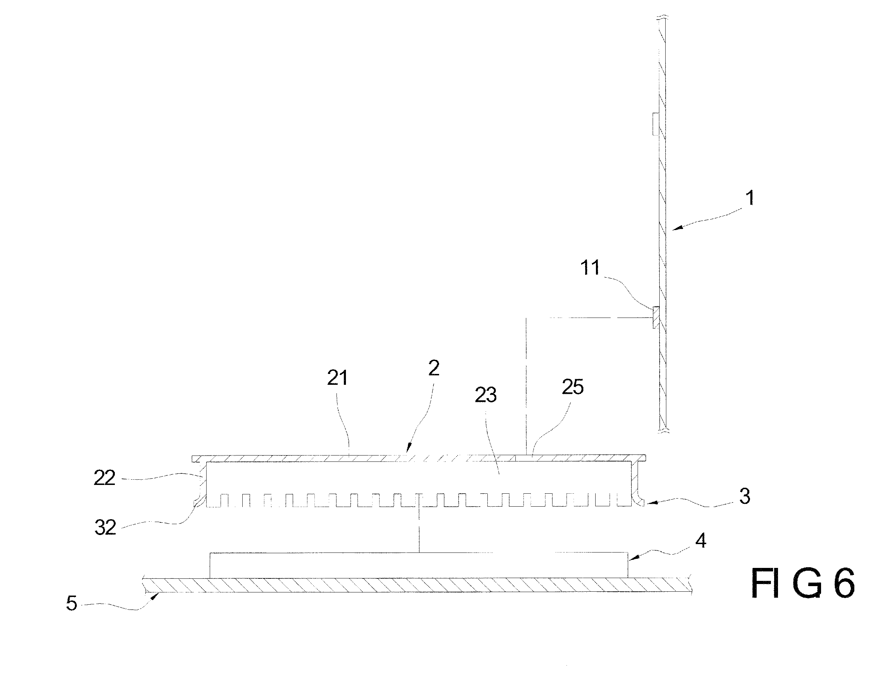

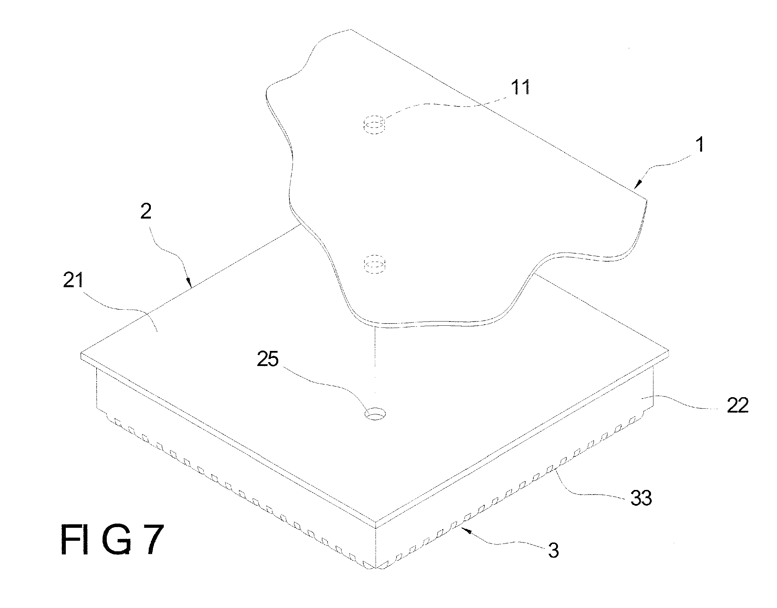

The elastic unit **3** are some elastic pieces **32, 33** integrally formed with the bottom edge of the side plate **22** of the shielding cover **2** and the elastic pieces **32** can be curve extended outwardly (shown in Fig. 5 and Fig. 6) or curved extended inwardly (shown in Fig. 7 and Fig. 8). When the housing **1** combines with the circuit board **5,** the shielding cover **2** is covered on an outside of the electronic component **4,** and the elastic pieces **32, 33** are pressed the top surface of the circuit board **5** so that the elastic pieces **32, 33** are disposed between the side plate **22** of the shielding cover **2** and the circuit board **5** to contact rigidly the shielding cover **2** and the circuit board **5.**

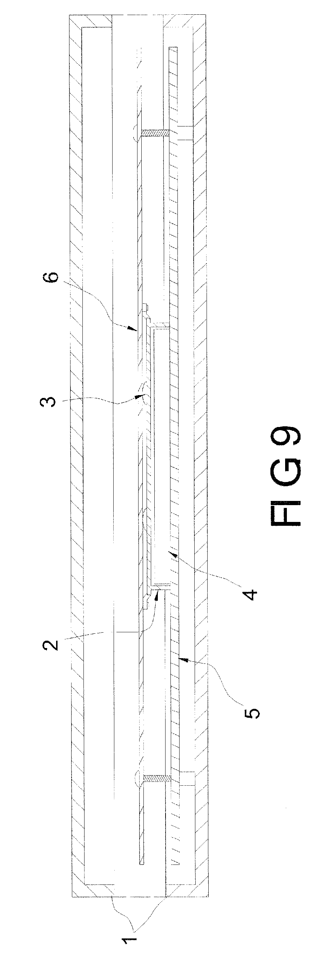

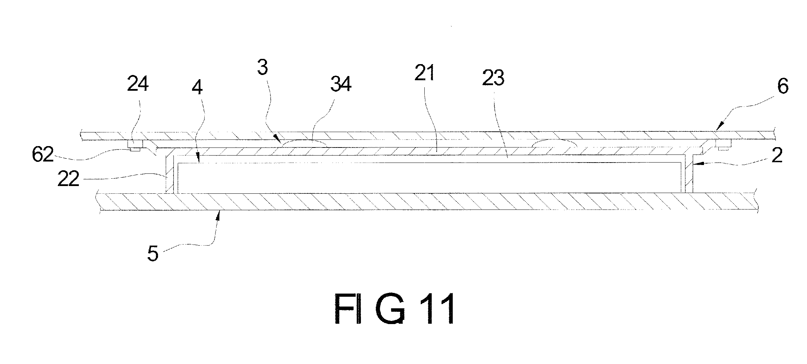

References are shown as in Fig. 9 and Fig. 11. In the embodiment, the electronic device has a middle board **6** therein, and the shielding cover **2** is disposed on the middle board **6.** The middle board **6** is a plate made of metal, plastic, or other materials, and the middle board **6** is also called as an inner board without having a limited shape. An edge of the middle board **6** has a plurality of fixed holes **61** to make the middle board **6** be firmly locked in the electronic device by the screws.

The middle board **6** is firmed fixed on the circuit board **5** or the housing **1,** however, the fixed way is not limited. The middle board **6** can be fixed on the circuit board **5** or the housing **1** of the electronic device by using a method of heat-melting, rivet-jointing, spot-welding, fastening-jointing, or spiral-jointing. The middle board **6** has a plurality of connecting elements **62** thereon and the connecting elements **62** can be integrally formed with the middle board **6,** or formed on the middle board **6** by using a combining method. In this embodiment, the connecting elements **62** are made of fusible material, and the connecting elements **62** can be inserted into the corresponding connecting holes **25** and fixed to the connecting holes **25** by using a heat-melting way so that the shielding cover **2** can be connected to a position corresponded to the electronic component **4** on the middle board **6.** The shielding cover **2** can be connected not only by using a heat-melting way on the middle board 6 but also by using a rivet-jointing, spot-welding, fastening-jointing, or spiral-jointing way.

A plurality of bumps **34** are formed on the top plate **21** of the shielding cover **2** by using a punching way, and the elastic unit **3** is composed of the bumps **34.** The bumps **34** are protruded on a top surface of the top plate **21** to press a bottom surface of the middle board **6** so as to provide a pressed downwardly force to the shielding cover **2** to contact rigidly a bottom edge of the shielding cover **2** and a top surface of the circuit board **5.**

When the housing **1** combines with the middle board **6** fixed in the electronic component **4,** the shielding cover **2** is covered on an outside of the electronic component **4** to provide an EMI shielding effect so that the electronic component **4** can't be influenced by the EMI.

Because the shielding cover **2** doesn't be welded on the circuit board **5** by using SMT processing, the shielding cover **2** is adapted in various materials to reduce substantially material costs. Further, if the electronic component **4** needs to be maintained only if separating the housing **1** and the circuit board **5,** or opening the housing **1** to separate the housing **1,** the middle board **6** and the circuit board **5** so as to apart the electronic component **4** from the shielding cover **2,** and it is easily to cover the shielding cover **2** on the outside of the electronic component **4** as long as to assemble the housing **1** and the circuit board **5** or fix the middle board **6** in the electronic device without installing extra back-shielding upper cover.

Although the present invention has been described with reference to the preferred embodiment thereof, it will be understood that the invention is not limited to the details thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A shielding device for EMI shielding disposed on a housing of an electronic device with an electronic component disposed on a circuit board, comprising:
a shielding cover connected on the housing;
an elastic unit disposed on the shielding cover; and
the shielding cover covered on an outer portion of the electronic component.

2. The shielding device for EMI shielding as claimed in claim 1, wherein the housing has a plurality of connecting elements disposed thereon and the shielding cover has a plurality of connecting holes disposed thereon, and the connecting elements are connected with the connecting holes.

3. The shielding device for EMI shielding as claimed in claim 1, wherein the shielding cover is a metal element.

4. The shielding device for EMI shielding as claimed in claim 1, wherein the shielding cover has a top plate and a side plate extended downwardly from periphery of the top plate, a containing space is formed between the top plate and the side plate, and the electronic element is contained in the containing space.

5. The shielding device for EMI shielding as claimed in claim 1, wherein the shielding cover is connected on the housing by using a method of heat-melting, rivet-jointing, spot-welding, fastening-jointing, or spiral-jointing.

6. The shielding device for EMI shielding as claimed in claim 1, wherein the elastic unit is disposed on a bottom edge of the shielding cover, and the elastic unit is pressed on a top surface of the circuit board.

7. The shielding device for EMI shielding as claimed in claim 6, wherein the elastic unit is a colloid connected between the bottom edge of the shielding cover and the circuit board.

8. The shielding device for EMI shielding as claimed in claim 6, wherein the elastic unit are a plurality of elastic pieces connected on the bottom edge of the shielding cover, and the elastic pieces are pressed on the top surface of the circuit board.

9. The shielding device for EMI shielding as claimed in claim 1, wherein the elastic unit is disposed on a top of the shielding cover, and has a plurality of bumps pressed on a bottom surface of the housing to press the bottom edge of the shielding cover on the top surface of the circuit board.

10. The shielding device for EMI shielding as claimed in claim 1, wherein the elastic unit is integrally formed with the shielding cover.

11. The shielding device for EMI shielding as claimed in claim 1, wherein the elastic unit is formed on the shielding cover by using a combining method.

12. A shielding device for EMI shielding disposed in an electronic device with an housing, a circuit board disposed in the housing, and an electronic component disposed on the circuit board, comprising:
a middle board disposed in the electronic device; and
a shielding cover disposed on the middle board and covered on an outer portion of the electronic component.

13. The shielding device for EMI shielding as claimed in claim 12, wherein the middle board has a plurality of fixed holes to firmly lock screws in the electronic device.

14. The shielding device for EMI shielding as claimed in claim 12, wherein the middle board is fixed in the electronic device by using a method of heat-melting, rivet-jointing, spot-welding, fastening-jointing, or spiral-jointing.

15. The shielding device for EMI shielding as claimed in claim 12, wherein the middle board is fixed on the circuit board.

16. The shielding device for EMI shielding as claimed in claim 12, wherein the middle board is fixed on the housing.

17. The shielding device for EMI shielding as claimed in claim 12, wherein the middle board has a plurality of connecting elements disposed thereon and the shielding cover has a plurality of connecting holes disposed thereon, and the connecting elements are connected with the connecting holes.

18. The shielding device for EMI shielding as claimed in claim 12, wherein the shielding cover is connected on the middle board by using a method of heat-melting, rivet-jointing, spot-welding, fastening-jointing, or spiral-jointing.

19. The shielding device for EMI shielding as claimed in claim 12, wherein the shielding cover is integrally formed with the middle board.
